# EUROPEAN PATENT SPECIFICATION

(11) **EP 4 170 899 B1**
(45) Date of publication and mention of the grant of the patent: **13.08.2025**
(21) Application number: 20944756.4
(22) Date of filing: 14.11.2020
(51) Int. Cl.: H02S 40/34, H02S 40/36, H01L 31/048

(54) **LOW-LINE-LOSS PHOTOVOLTAIC ARRAY STRUCTURE**
FOTOVOLTAISCHE ARRAYSTRUKTUR MIT GERINGEM LEITUNGSVERLUST
STRUCTURE DE RÉSEAU PHOTOVOLTAÏQUE À FAIBLE PERTE DE LIGNE

(30) Priority: 04.07.2020 CN 202010635067; 04.07.2020 CN 202021285374 U
(43) Date of publication of application: 26.04.2023
(73) Proprietor: Sunman (Zhenjiang) Co., Ltd., Zhenjiang, Jiangsu 212200 (CN)
(72) Inventor: SHI, Zhengrong, Zhenjiang, Jiangsu 212200 (CN); CUI, Biao, Zhenjiang, Jiangsu 212200 (CN); XIE, Taotao, Zhenjiang, Jiangsu 212200 (CN); LIAN, Chengrong, Zhenjiang, Jiangsu 212200 (CN)
(74) Representative: Meyer-Dulheuer MD Legal Patentanwälte PartG mbB
(86) International application number: PCT/CN2020/128869
(87) International publication number: WO 2022/007289

(56) References cited:
- EP-A2- 0 828 034
- CN-A- 105 280 738
- CN-A- 105 280 739
- CN-A- 108 023 537
- CN-A- 111 119 421
- CN-U- 202 758 910
- CN-U- 207 099 024
- DE-U1- 202017 107 737
- US-A1- 2015 326 177
- US-A1- 2016 315 209
- US-A1- 2019 319 148

## Description

The present application claims priority to Chinese patent application No. 2020106350678 entitled "PHOTOVOLTAIC ARRAY STRUCTURE HAVING LOW LINE LOSS" and Chinese patent application No. 202021285374X entitled "LAMINATED LIGHTWEIGHT FLEXIBLE CRYSTALLINE SILICON PHOTOVOLTAIC MODULE" that are filed to the China National Intellectual Property Administration on July 4, 2020.

### TECHNICAL FIELD

The present invention belongs to the technical field of photovoltaics, and particularly relates to a photovoltaic array structure having low line loss.

### BACKGROUND

A photovoltaic array usually refers to a photovoltaic power generation product that uses a plurality of photovoltaic modules to be connected in series and/or in parallel by means of cable connectors, and finally converges current to an inverter by means of a direct current cable in order to satisfy power generation requirements of high voltage and high power. The photovoltaic modules are generally photovoltaic array units in which several cell pieces are connected in series and/or in parallel by means of conductive grid lines. Such a photovoltaic array is disclosed in document DE 202017107737 U1 for example.

The applicant found that there were a wide range of technical solutions disclosed in the prior art to reduce internal current loss of the photovoltaic modules as photovoltaic array units. For example, internal current and internal loss of the photovoltaic modules can be reduced by using a half-cell technology or a lamination technology. By means of patent search, the applicant did not find any disclosure on the technical solution to reduce loss of a photovoltaic array that electrically connects the photovoltaic modules. However, the applicant found that it was necessary for the photovoltaic array to connect a wide range of photovoltaic modules by means of cables, so as to converge current. Specifically, the traditional photovoltaic array usually has junction boxes on short side directions (on back surfaces, or rarely on light-facing front surfaces) of the photovoltaic modules, and then electrically connects the junction boxes by means of direct current cables. This structure not only consumes a wide range of direct current cables, but also results in high line loss of the photovoltaic array.

Therefore, the inventor of the present application decided to seek a systematic technical solution to solve the above technical problem on the basis of years of research and development experience in the field of photovoltaics and theoretical knowledge. On the basis of providing the idea of low line loss, the applicant further provided an original color steel tile and an original photovoltaic mounting system solution. In order to better illustrate technical effects of the original color steel tile and the original photovoltaic mounting system solution, the applicant concentrated on providing batch patent applications.

### SUMMARY

In view of this, the objective of the present invention is to provide a photovoltaic array structure having low line loss, which may obviously shorten a thread of a direct current cable in the photovoltaic array structure and reduce line loss inside the photovoltaic array structure.

The technical solution used by the present invention is given by the subject-matter of the independent claim 1 and is as follows:
a photovoltaic array structure having low line loss includes several photovoltaic modules as photovoltaic array units, where each photovoltaic module includes one photovoltaic cell string or a plurality of photovoltaic cell strings distributed row by row or column by column and connected in series and/or in parallel, and the photovoltaic module includes a long side and a short side, a first end edge junction box and a second end edge junction box being arranged on light-facing surfaces or surfaces facing away from light at two ends along a center line of the long side of the photovoltaic module respectively, and being located on the same side of the long side of the photovoltaic module, the junction boxes being electrically connected by means of bus bars, and the first end edge junction box and/or the second end edge junction box being electrically connected to end edge junction boxes of the photovoltaic module adjacent to the first end edge junction box and/or the second end edge junction box by means of cable connectors respectively.

Preferably, a spacing between the first end edge junction box and the second end edge junction box is not less than 200 mm.

Preferably, the photovoltaic module includes at least one intermediate junction box located between the first end edge junction box and the second end edge junction box, the junction boxes being located on the same side of the long side, at least one diode being arranged in the at least one junction box, and the diode being inversely connected in parallel between a positive electrode and a negative electrode of the photovoltaic cell string corresponding to the diode, and being used for bypass protection.

Preferably, a spacing range between the first end edge junction box and the second end edge junction box is 500 mm to 2000 mm.

The photovoltaic array structure having low line loss includes an A-type photovoltaic module column formed by connecting at least two A-type photovoltaic modules in series and a B-type photovoltaic module column formed by connecting at least two B-type photovoltaic modules in series, the A-type photovoltaic module column and the B-type photovoltaic module column being connected to each other in series and arranged on a mounting base surface by using alternating structures arranged in parallel;
the A-type photovoltaic module column including an A-type positive output terminal located at one end and an A-type negative output terminal located at the other end; the B-type photovoltaic module column including a B-type positive output terminal located at one end and a B-type negative output terminal located at the other end; the A-type positive output terminal being located at the same end as the B-type negative output terminal, and the A-type negative output terminal being located at the same end as the B-type positive output terminal; and the A-type negative output terminal being electrically connected to the B-type positive output terminal of the B-type photovoltaic module column adjacent to the A-type negative output terminal by means of a cable connector.

Preferably, each photovoltaic module includes at least two photovoltaic cell strings, each photovoltaic cell string including at least two cell pieces connected in series or connected in series in a laminated manner, the cell piece using an entire piece or a slice, and being a crystalline silicon wafer, and the full cell piece having a single-side length ranging from 100 mm to 260 mm.

Preferably, a package layer of the photovoltaic module includes a flexible composite film layer and/or a glass layer.

Preferably, the diode is arranged in each junction box, the plurality of photovoltaic cell strings distributed row by row or column by column and connected in series and/or in parallel are distributed in a direction of the long side, a single diode is inversely connected in parallel between the positive electrode and the negative electrode of the at least two photovoltaic cell strings distributed row by row or column by column, and the diodes are connected in series and are used for bypass protection of the photovoltaic cell strings corresponding to the diodes.

Preferably, 6n photovoltaic cell strings distributed column by column and connected in series and/or in parallel are distributed on the long side, and a single diode is inversely connected in parallel between the positive electrode and the negative electrode of every 2n photovoltaic cell strings distributed column by column, n being a positive integer equal to or greater than 1. Preferably, at least 2 photovoltaic cell strings distributed row by row, connected in parallel and including 6n cell pieces are distributed on the long side, and a single diode is inversely connected in parallel between the positive electrode and the negative electrode of every 2n, 3n, or 6n cell pieces in each row, n being a positive integer equal to or greater than 1.

Distribution of the photovoltaic cell strings in the direction of the long side may facilitate appropriate voltage output by the photovoltaic module, and moreover, it is advantageous for the present invention to arrange the end edge junction boxes at two ends of the same side in the direction of the long side, such that usage amount of the cables for electric connection between the junction boxes can be significantly reduced.

Preferably, the photovoltaic module uses an integrated assembly of photovoltaic color steel tiles.

The present application has the following positive technical effects:
1. The present application inventively provides that the end edge junction boxes are arranged on the same side of the light-facing surfaces or the surfaces facing away from light at the two ends along the center line of the long side of the photovoltaic module, and the end edge junction boxes are electrically connected by means of the bus bars known from the photovoltaic modules, and it is only necessary to electrically connect the end edge junction boxes to the end edge junction boxes of other photovoltaic modules by means of the cable connectors, such that usage amount of the cables for electric connection between the junction boxes can be greatly reduced. After a plurality of photovoltaic modules are connected in series or in parallel to form the photovoltaic array structure, the present invention can obviously shorten a thread of a direct current cable in the photovoltaic array structure, and reduce line loss inside the photovoltaic array structure; and the present invention further preferably provides that one or more intermediate junction boxes are arranged between the end edge junction boxes, and the intermediate junction box can serve as a bypass protection structure for the photovoltaic cell string, and can further satisfy a photovoltaic module structure having a large spacing (such as the spacing range of 500 mm to 2000 mm, or a larger spacing range) between the first end edge junction box and the second end edge junction box, such that the present invention can have better commonality and universality.
2. The present application further specifically preferably applies a low line loss technology provided in point 1 above to the laminated photovoltaic module, and well solves the defect that a laminated photovoltaic module product has a long thread of a direct current cable and high line loss since the laminated photovoltaic module product exists between junction boxes all the time, and moreover, the present invention further particularly provides that the flexible composite film layer is used for packaging the laminated photovoltaic module product, such that packaging weight of the laminated photovoltaic module is effectively reduced, a curved surface mounting effect is achieved, and scale popularization and application of the laminated photovoltaic module product are strongly facilitated.
3. The present application provides a preferred color steel tile structure for mounting the photovoltaic module. Specifically, fixed mounting connection between the color steel tiles is achieved by means of a clamping structure, and moreover, an anti-slip cover for shielding and protecting a side surface of the photovoltaic module is directly arranged on a clamping edge, such that during specific application, the junction box located on one side of the light-facing surface of the photovoltaic module can be directly shielded and protected, and service life of the junction box is ensured.
4. The present application provides the preferred integrated assembly of the photovoltaic color steel tiles. Firstly, color steel tile substrates of clamping edges are arranged on two sides of the integrated assembly of the photovoltaic color steel tiles, and the photovoltaic module is arranged in a limiting groove between the clamping edges, such that it is advantageous to rapidly position and mount the photovoltaic module, and moreover, during practical application, a mounting procedure of the integrated assembly of the photovoltaic color steel tiles provided in the present application can be directly completed in a factory, such that a mounting workload during subsequent application of a photovoltaic mounting system is greatly reduced.
5. The present application inventively provides the preferred integrated assembly of the photovoltaic color steel tiles, and specifically provides a first color steel tile and a second color steel tile each having the clamping edge. The first color steel tile and the second color steel tile are oppositely arranged to form a limiting hollowed-out groove for fixedly mounting the photovoltaic module, and during practical application and mounting, conventional contact between the color steel tile and the mounting base surface is directly replaced with a back surface of the photovoltaic module, such that usage amount of materials for the color steel tile is obviously reduced, manufacturing cost is effectively reduced, overall mounting weight of the integrated assembly of the photovoltaic color steel tiles is significantly reduced, and the integrated assembly of the photovoltaic color steel tiles can be mounted in combination with various specifications of photovoltaic modules without being limited by a size of a wide side of the photovoltaic module, such that commonality is excellent; and moreover, the hollowed-out integrated assembly of the photovoltaic color steel tiles provided in the present application is further extremely convenient to mount and maintain subsequently, and can be widely applied in mounting environments having different mounting characteristics, including being extremely suitable for being directly mounted and used on waste color steel tile building roofs, such that a mounting procedure is greatly simplified while mounting strength is ensured.
6. The present application inventively provides a photovoltaic mounting system formed by connecting the A-type photovoltaic module column and the B-type photovoltaic module column in series and using alternating structures arranged in parallel. The negative output terminal of the B-type photovoltaic module column is located at the same end as the positive output terminal of the A-type photovoltaic module column, the positive output terminal of the B-type photovoltaic module column is located at the same end as the negative output terminal of the A-type photovoltaic module column, and under a particular structure, it is ensured that the thread of the direct current cable between the negative output terminal of the A-type photovoltaic module column and the positive output terminal of the B-type photovoltaic module column is considerably shortened, such that a wiring structure of the thread of the long direct current cable is effectively avoided, and line loss of the photovoltaic mounting system is obviously reduced.
7. On the basis of point 6 above, the present application further uses the perforated wiring structure for electric connection between the negative output terminal of the A-type photovoltaic module column and the positive output terminal of the B-type photovoltaic module column without relying on a lower cornice wiring structure, such that the thread of the direct current cable is greatly shortened, line loss is further reduced, and the perforated wiring structure is simple and convenient to implement.
8. The present application further preferably provides the photovoltaic mounting system having low line loss, which is formed by connecting the A-type photovoltaic modules and the A-type photovoltaic modules (which serve as the B-type photovoltaic modules) after 180-degree planar rotation in series and uses alternating structures arranged in parallel, and it is unnecessary to specially arrange two models of photovoltaic modules, such that a production procedure of the photovoltaic module is simplified, and management during mass production is facilitated; and it is only necessary for the present application to perform alternating 180-degree planar rotation on the A-type photovoltaic module during system mounting, and a single-set double-row docking box structure is formed by means of the particular structure, such that it is ensured that the thread of the direct current cable between the negative output terminal of the A-type photovoltaic module column and the positive output terminal of the B-type photovoltaic module column is shortened to the greatest extent, line loss is reduced to the greatest extent, and an excellent level of line management is achieved.

### BRIEF DESCRIPTION OF THE DRAWINGS

FIG. 1 is a schematic structural diagram of a 2-series 1/2 slice type photovoltaic module 10a of a photovoltaic array having low line loss in Embodiment 1 of the present invention;
FIG. 2 is a schematic structural diagram of a 3-series 1/3 slice type photovoltaic module 10b of a photovoltaic array having low line loss in Embodiment 2 of the present invention;
FIG. 3 is a schematic structural diagram of a 4-series entire piece type photovoltaic module 10c of a photovoltaic array having low line loss in Embodiment 3 of the present invention;
FIG. 4 is a schematic structural diagram of a 5-series 1/2 slice type photovoltaic module 10d of a photovoltaic array having low line loss in Embodiment 4 of the present invention;
FIG. 5 is a schematic structural diagram of a 6-series entire piece type photovoltaic module 10e of a photovoltaic array having low line loss in Embodiment 5 of the present invention;
FIG. 6 is a schematic structural diagram of electric connection of a laminated lightweight flexible crystalline silicon photovoltaic module 10f (5-series 1/5 slice type) in Embodiment 6 of the present invention;
FIG. 7 is a schematic structural diagram of a photovoltaic module 10g (2-series 1/2 slice type) with junction boxes mounted on surfaces facing away from light in Embodiment 7 of the present invention;
FIG. 8 is a schematic structural diagram of a color steel tile for mounting a photovoltaic module in Embodiment 8 of the present invention;
FIG. 9 is a schematic structural diagram of a color steel tile for mounting a photovoltaic module in Embodiment 9 of the present invention;
FIG. 10 is a schematic structural diagram of an integrated assembly of photovoltaic color steel tiles in Embodiment 10 or Embodiment 11 of the present invention;
FIG. 11 is a schematic diagram of an end surface structure of the integrated assembly of the photovoltaic color steel tiles in Embodiment 10 of the present invention;
FIG. 12 is a schematic diagram of an end surface structure of the integrated assembly of the photovoltaic color steel tiles in Embodiment 11 of the present invention;
FIG. 13 is a schematic diagram of a partial structure when a photovoltaic mounting system is applied to a building roof in Embodiment 12 of the present invention;
FIG. 14 is an enlarged view of a structure at a position A in FIG. 13;
FIG. 15 is a schematic structural diagram of electric connection of an A-type photovoltaic module in Embodiment 12 of the present invention;
FIG. 16 is a schematic structural diagram of electric connection of a B-type photovoltaic module in Embodiment 12 of the present invention;
FIG. 17 is a schematic structural diagram of a building structure when a photovoltaic mounting system is applied to a building roof in Embodiment 13 of the present invention;
FIG. 18 is a schematic structural diagram of electric connection of an A-type photovoltaic module in Embodiment 13 of the present invention;
FIG. 19 is a schematic structural diagram of electric connection of a B-type photovoltaic module in Embodiment 13 of the present invention;
FIG. 20 is a partial diagram of a perforated wiring structure of a photovoltaic mounting system in Embodiment 14 of the present invention;
FIG. 21 is a schematic structural diagram of a photovoltaic mounting system having low line loss in Embodiment 15 of the present invention;
FIG. 22 is a schematic structural diagram of connection between an A-type photovoltaic module and a B-type photovoltaic module in Embodiment 15 of the present invention;
FIG. 23 is an enlarged view of a structure at a position B in FIG. 22;
FIG. 24 is a schematic structural diagram of a hidden mounting seat in FIG. 22; and
FIG. 25 is a schematic structural diagram of a junction box cover plate 50a and a junction box edge cover plate 50b in Embodiment 15 of the present invention.

### DESCRIPTION OF EMBODIMENTS

The present invention discloses a photovoltaic array structure having low line loss. The photovoltaic array structure includes several photovoltaic modules as photovoltaic array units, where each photovoltaic module includes one photovoltaic cell string or a plurality of photovoltaic cell strings distributed row by row or column by column and connected in series and/or in parallel, and the photovoltaic module includes a long side and a short side, a first end edge junction box and a second end edge junction box being arranged on light-facing surfaces or surfaces facing away from light at two ends along a center line of the long side of the photovoltaic module respectively, and being located on the same side of the long side of the photovoltaic module, the junction boxes being electrically connected by means of bus bars, and the first end edge junction box and/or the second end edge junction box being electrically connected to end edge junction boxes of the photovoltaic module adjacent to the first end edge junction box and/or the second end edge junction box by means of cable connectors respectively.

In order to enable those skilled in the art to better understand the technical solutions in the present invention, the technical solutions in the embodiments of the present invention will be clearly and completely described below with reference to the accompanying drawings in the embodiments of the present invention, and it is obvious that the embodiments described are merely some rather than all of the embodiments of the present invention. On the basis of the embodiments in the present invention, all other embodiments obtained by those of ordinary skill in the art without making inventive efforts should all fall within the scope of protection of the present invention.

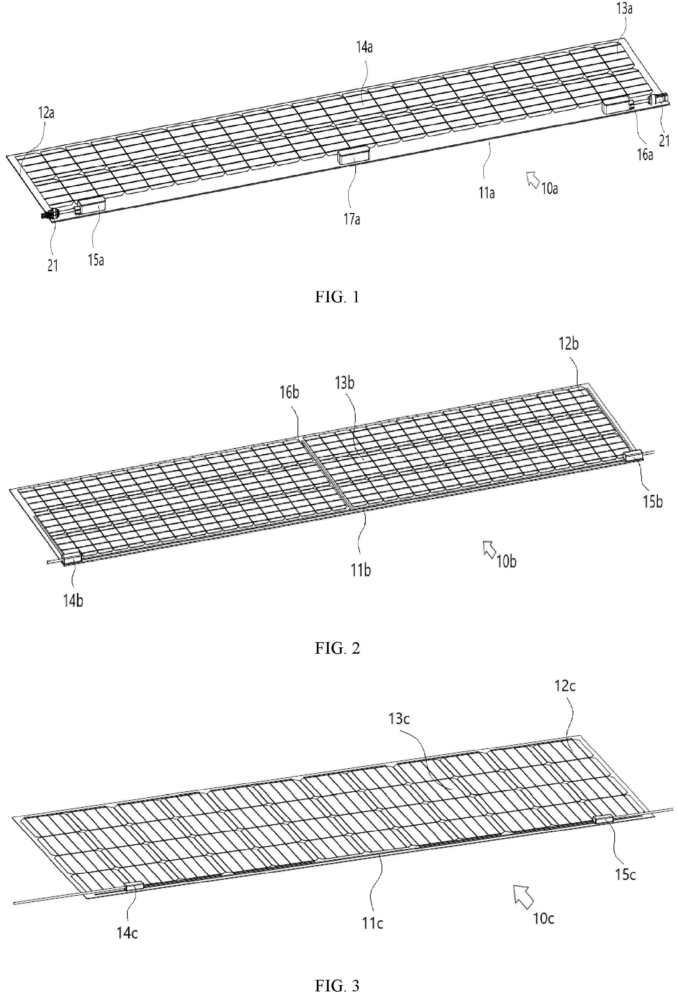

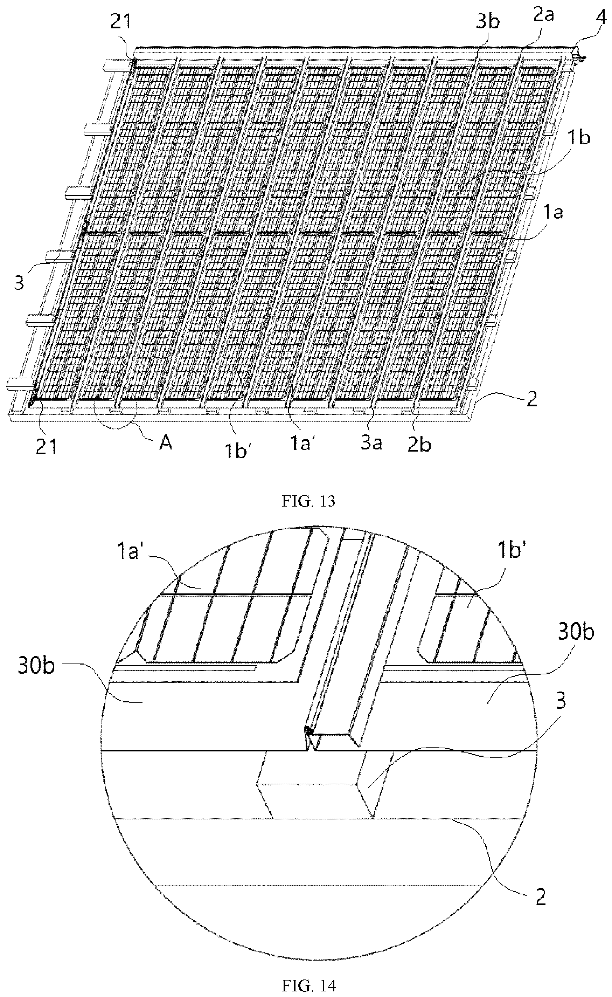

**Embodiment 1:** With reference to FIG. 1 in combination with FIG. 13, a photovoltaic array structure having low line loss includes several photovoltaic modules 10a as photovoltaic array units. Preferably, in this implementation, the photovoltaic module 10a includes a long side 11a and a wide side 12a, where two photovoltaic cell strings 13a distributed row by row and connected in parallel are distributed on the long side 11a, and each photovoltaic cell string 13a includes 12 (6n, n=2) cell pieces 14a connected in series. Preferably, in this implementation, the cell piece 14a uses a 1/2 slice type crystalline silicon wafer, which is referred to as 2-series 1/2 slice type photovoltaic module 10a in this embodiment. The full cell piece 14a may have a single-side length ranging from 100 mm to 260 mm. More preferably, the full cell piece may have a single-side length ranging from 120 mm to 220 mm. For example, the full cell piece 14a may have a single-side length of 156 mm, 158 mm, 166 mm or 210 mm. A specific specification may be selected according to a specification of the full cell piece and output voltage and mounting requirements of the photovoltaic module 10a. These are all conventional technical means that may be made by those skilled in the art on the basis of contents described in the present application.

A first end edge junction box 15a and a second end edge junction box 16a are arranged on light-facing surfaces at two ends along a center line of the long side 11a of the photovoltaic module 10a, the first end edge junction box 15a and the second end edge junction box 16a are located at the same side of the long side 11a of the photovoltaic module 10a, and the junction boxes 15a, 16a are electrically connected by means of a bus bar (not shown in the figure). Moreover, the first end edge junction box 15a and the second end edge junction box 16a are electrically connected to end edge junction boxes of the photovoltaic module adjacent to the first end edge junction box and the second end edge junction box by means of cable connectors 21 respectively. In other implementations, one of the end edge junction boxes may also be directly converged to a combiner box by means of the cable connector. These are all common general knowledge of those skilled in the art, and are not particularly limited in this embodiment. Preferably, a spacing between the first end edge junction box 15a and the second end edge junction box 16a is not less than 200 mm, which may effectively reduce usage amount of a direct current cable.

In this implementation, during preparation of the photovoltaic module 10a, the photovoltaic cell string 13a and package layers (which are a front package layer and a back package layer respectively) located on the light-facing surface and a surface facing away from light are packaged into a whole by means of a well-known lamination process or other well-known preparation processes, and the front package layer and the back package layer may use corresponding package layer materials in the prior art. Preferably, in this implementation, the front package layer and/or the back package layer may include a flexible composite film layer, or may use a glass layer, or may use a double-glass packaging structure. Any replacement made on the front package layer and the back package layer falls within the applicable implementation scope of the present application, and may also obtain the same or similar technical effects as this embodiment, which is not limited in this embodiment.

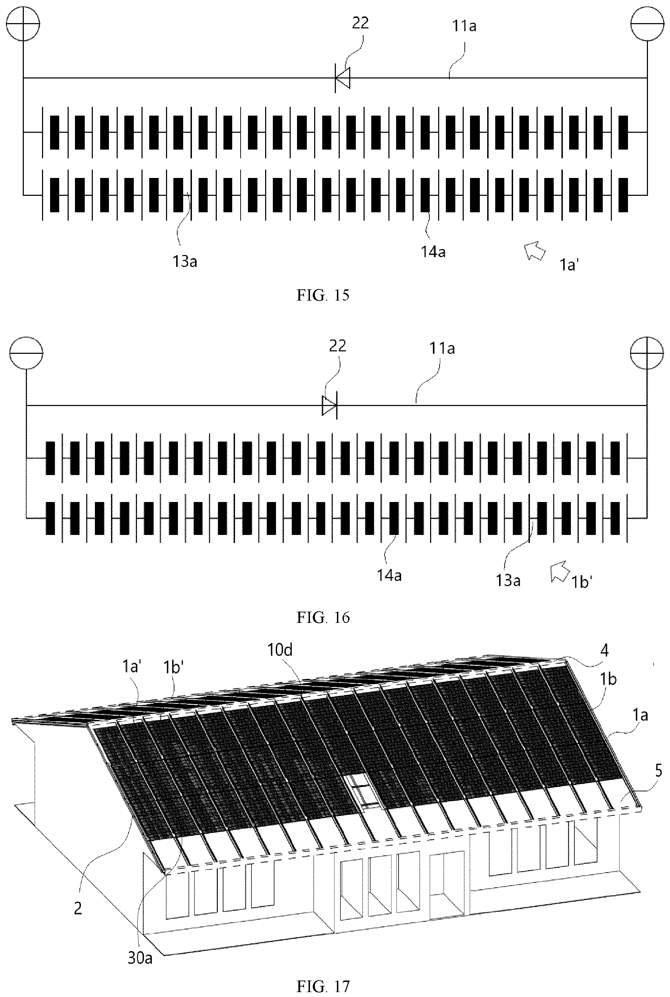

In this implementation, the photovoltaic module 10a further includes an intermediate junction box 17a located between the first end edge junction box 15a and the second end edge junction box 16a, and the junction boxes 15a, 16a, 17a are located on the same side of the long side 11a. Preferably, in this implementation, with reference to FIG. 15 or 16, a diode 22 is arranged in the intermediate junction box 17a, the diode 22 corresponds to two rows of photovoltaic cell strings 13a (each row of photovoltaic cell strings includes 12 cell pieces connected in series), and a single diode 22 is inversely connected in parallel between a positive electrode and a negative electrode of each row of photovoltaic cell strings 13a and is used for bypass protection.

A spacing range between the first end edge junction box 15a and the second end edge junction box 16a is 500 mm to 2000 mm, or larger. Specifically, in this implementation, the long side 11a has a length ranging from 900 mm to 1100 mm, and a spacing between the first end edge junction box 15a and the second end edge junction box 16a is 800 mm to 850 mm, which may obviously reduce usage amount of the direct current cable.

During subsequent practical mounting of the photovoltaic module 10a in Embodiment 1, an integrated assembly of photovoltaic color steel tiles in Embodiment 10 or Embodiment 11 may be directly used. During subsequent mounting of Embodiment 1, the technical solution of Embodiment 12 may be directly used to obtain the photovoltaic array structure having low line loss, and during implementation, an A-type photovoltaic module 1a' and a B-type photovoltaic module 1b' as shown in FIG. 15 and FIG. 16 are manufactured in a factory in advance. Directions of a positive output terminal and a negative output terminal of the B-type photovoltaic module 1b' are opposite to those of the A-type photovoltaic module 1a', and a specific implementation process may directly use Embodiment 12.

**Embodiment 2:** Remaining technical solutions of Embodiment 2 are the same as those of Embodiment 1, and the differences lie in that in Embodiment 2, with reference to a photovoltaic module 10b as shown in FIG. 2, three photovoltaic cell strings 12b distributed row by row and connected in series are distributed on a long side 11b, and each photovoltaic cell string 12b includes 36 (6n, n=6) cell pieces 13b connected in series. Preferably, in this implementation, the cell piece 13b uses a 1/3 slice type crystalline silicon wafer, which is referred to as a 3-series 1/3 slice type photovoltaic module 10b in this embodiment. A first end edge junction box 14b and a second end edge junction box 15b are arranged on light-facing surfaces at two ends along a center line of the long side 11b of the photovoltaic module 10b respectively, the first end edge junction box 14b and the second end edge junction box 15b are located at the same side of the long side 11b, the junction boxes 14b, 15b are electrically connected by means of a bus bar 16b, and no intermediate junction box is arranged in Embodiment 2. A diode (well-known structure, which is not shown in the figure) is arranged in each of the first end edge junction box 14b and the second end edge junction box 15b, the diode corresponds to 18 (3n, n=6) cell pieces 13b connected in series in three rows of photovoltaic cell strings 12b, and a single diode is inversely connected in parallel between a positive electrode and a negative electrode of 18 cell pieces 13b connected in series in each row and is used for bypass protection.

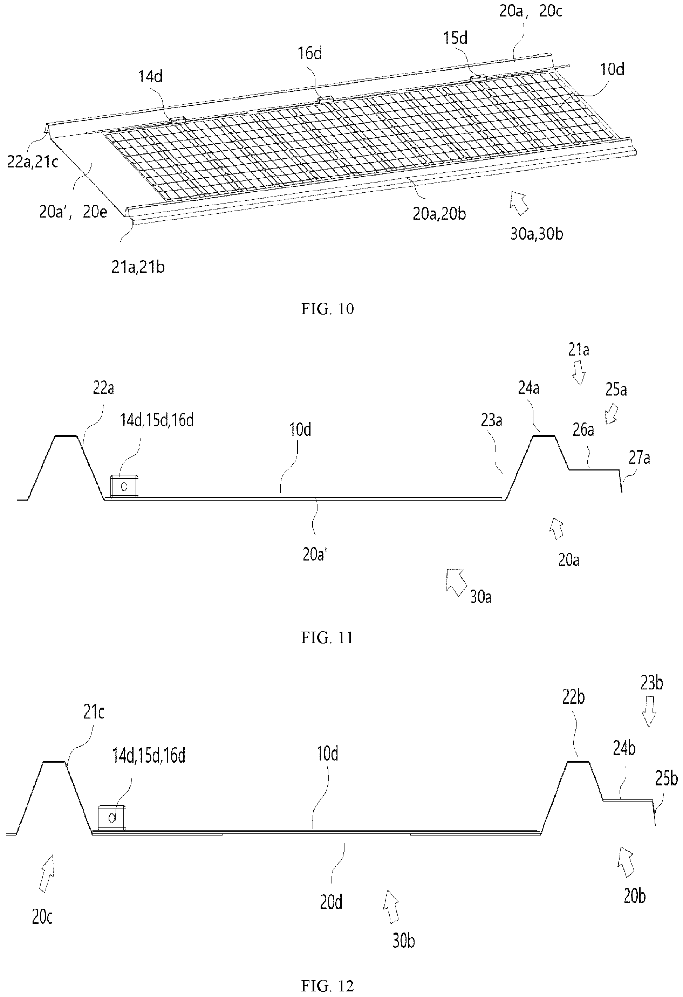

**Embodiment 3:** Remaining technical solutions of Embodiment 3 are the same as those of Embodiment 1, and the differences lie in that in Embodiment 3, with reference to a photovoltaic module 10c as shown in FIG. 3, 12 (6n, n=2) photovoltaic cell strings 12c distributed column by column and connected in series are distributed on a long side 11c, and each photovoltaic cell string 12c includes four cell pieces 13c connected in series. Preferably, in this implementation, the cell piece 13c uses an entire piece type crystalline silicon wafer, which is referred to as a 4-series entire piece type photovoltaic module 10c in this embodiment. A first end edge junction box 14c and a second end edge junction box 15c are arranged on light-facing surfaces at two ends along a center line of the long side 11c of the photovoltaic module 10c respectively, the first end edge junction box 14c and the second end edge junction box 15c are located at the same side of the long side 11c, the junction boxes 14c, 15c are electrically connected by means of a bus bar (not shown in the figure), and no intermediate junction box is arranged in Embodiment 3. A diode (well-known structure, which is not shown in the figure) is arranged in each of the first end edge junction box 14c and the second end edge junction box 15c, each diode corresponds to every 6 (3n, n=2) photovoltaic cell strings 12c distributed column by column, and a single diode is inversely connected in parallel between a positive electrode and a negative electrode of every six photovoltaic cell strings 12c distributed column by column and is used for bypass protection. In other implementations, a plurality of intermediate junction boxes may be arranged according to requirements of a bypass protection structure of the photovoltaic module, which is not exclusively limited in the present application.

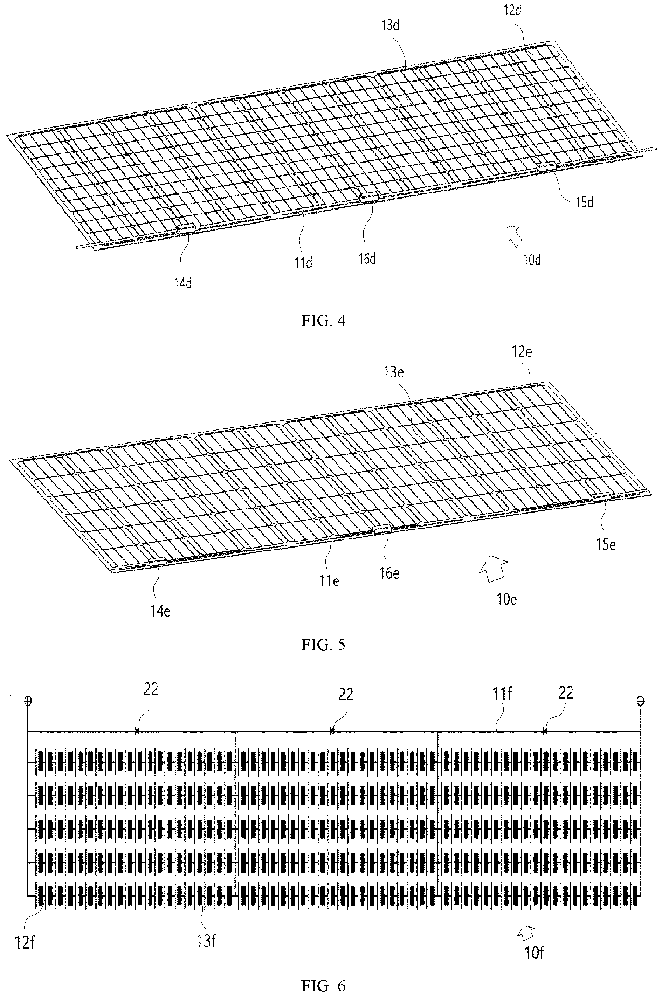

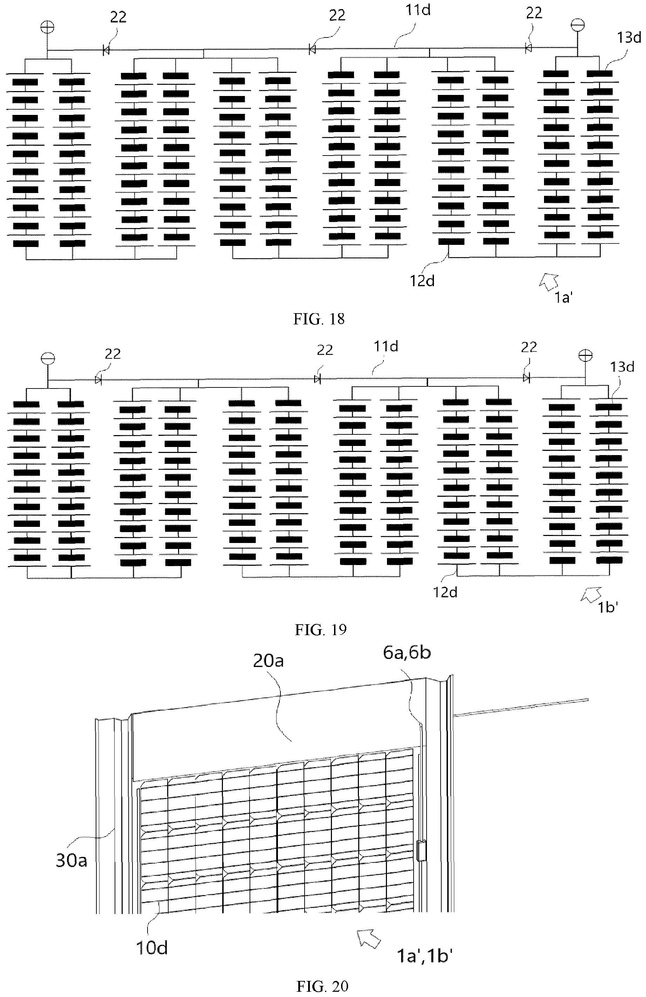

**Embodiment 4:** Remaining technical solutions of Embodiment 4 are the same as those of Embodiment 1, and the differences lie in that in Embodiment 4, with reference to a photovoltaic module 10d as shown in FIG. 4 and in combination with FIG. 18 and FIG. 19, 12 (6n, n=2) photovoltaic cell strings 12d distributed column by column and connected in series are distributed on a long side 11d, and each photovoltaic cell string 12d includes 10 cell pieces 13d connected in series. Preferably, in this implementation, the cell piece 13d uses a 1/2 slice type crystalline silicon wafer, which is referred to as a 5-series 1/2 slice type photovoltaic module 10d in this embodiment. A diode 22 is arranged in each of junction boxes 14d, 15d, 16d, each diode 22 corresponds to 4 (2n, n=2) photovoltaic cell strings 12d distributed column by column, a single diode 22 is inversely connected in parallel between a positive electrode and a negative electrode of every four photovoltaic cell strings 12d distributed column by column, and the diodes 22 are connected in series and are used for bypass protection of the photovoltaic cell strings 12d corresponding to the diodes.

**Embodiment 5:** Remaining technical solutions of Embodiment 5 are the same as those of Embodiment 1, and the differences lie in that in Embodiment 5, with reference to a photovoltaic module 10e as shown in FIG. 5, 12 (6n, n=2) photovoltaic cell strings 12e distributed column by column and connected in series are distributed on a long side 11e, and each photovoltaic cell string 12e includes six cell pieces 13e connected in series. Preferably, in this implementation, the cell piece 13e uses an entire piece type crystalline silicon wafer, which is referred to as a 6-series entire piece type photovoltaic module 10e in this embodiment. In this implementation, a diode (well-known structure, which is not shown in the figure) is arranged in each of junction boxes 14e, 15e, 16e, each diode corresponds to every 4 (2n, n=2) photovoltaic cell strings 12e distributed column by column, and a single diode is inversely connected in parallel between a positive electrode and a negative electrode of every four photovoltaic cell strings 12e distributed column by column, and is used for bypass protection.

**Embodiment 6:** A laminated lightweight flexible crystalline silicon photovoltaic module 10f includes a front package layer, a laminated crystalline silicon photovoltaic cell string, and a back package layer that are laminated and packaged into a whole, where the front package layer and the back package layer each include a flexible composite film layer, the flexible composite film layer having weight not exceeding 2 kg/cm². Preferably, the flexible composite film layer uses a composite fiber cloth of a thermosetting powder coating. Specifically, preferably, in this implementation, the thermosetting powder coating uses an acrylic thermosetting powder coating or a polyester thermosetting powder coating. A packaging adhesive film layer is arranged between the front package layer and the laminated crystalline silicon photovoltaic cell string. The specific preferred material solution of the flexible composite film layer involved in the embodiment of the present application may directly refer to 201610685536.0. The technical solution described in 201610685240.9 has an excellent lightweight flexible effect. A front surface involved in this embodiment is a light-facing surface in Embodiment 1, and a back surface involved in this embodiment is a surface facing away from light in Embodiment 1.

Remaining technical solutions of junction boxes of Embodiment 6 are the same as those of Embodiment 4, and the differences lie in that in Embodiment 6, with reference to FIG. 6, five laminated crystalline silicon photovoltaic cell strings 12f distributed row by row and connected in parallel are distributed on a long side 11f, and each laminated crystalline silicon photovoltaic cell string 12f includes 60 cell pieces 13f connected in series in a laminated manner. Preferably, in this implementation, the cell piece 13f uses a 1/5 slice.

In this implementation, the junction boxes (not shown in the figure) are located at the same side of the long side 11f, a diode 22 is arranged in each junction box, each diode 22 corresponds to 20 (2n, n=10) cell pieces 13f connected in series in five rows of photovoltaic cell strings, and a single diode 22 is inversely connected in parallel between a positive electrode and a negative electrode of the 20 cell pieces 13f connected in series in each row and is used for bypass protection. In other implementations of this embodiment, the cell piece used in the laminated crystalline silicon photovoltaic cell string may further uses a 1/2 slice, a 1/3 slice, a 1/4 slice or a 1/6 slice according to practical requirements, which are equivalent embodiments of this embodiment, and will not be described in detail in the present application.

Same as Embodiment 1, the laminated lightweight flexible crystalline silicon photovoltaic module 10f of Embodiment 6 may be directly combined with and used in Embodiment 10 or Embodiment 11 during subsequent practical mounting, and the photovoltaic module 10a is used for replacing the laminated lightweight flexible crystalline silicon photovoltaic module to obtain an integrated assembly of photovoltaic color steel tiles. A photovoltaic array structure having low line loss may further be obtained directly from the technical solution of Embodiment 12. During implementation, an A-type laminated lightweight flexible crystalline silicon photovoltaic module and a B-type laminated lightweight flexible crystalline silicon photovoltaic module are manufactured in a factory in advance with reference to FIG. 15 and FIG. 16. Directions of a positive output terminal and a negative output terminal of the B-type laminated lightweight flexible crystalline silicon photovoltaic module are opposite to those of the A-type photovoltaic module, which are all conventional technical choices that may be made by those skilled in the art on the basis of Embodiment 12, and will not be repeated in this embodiment in order to save a description space.

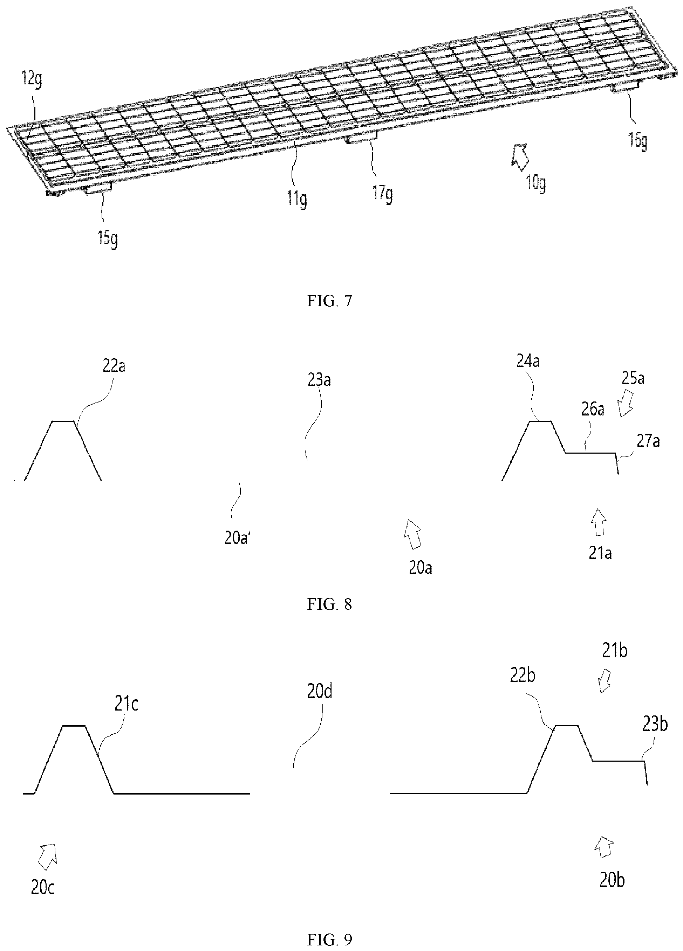

**Embodiment 7:** Remaining technical solutions of Embodiment 7 are the same as those of Embodiment 1, and the differences lie in that in Embodiment 7, with reference to a photovoltaic module 10g as shown in FIG. 7, the photovoltaic module 10g includes a long side 11g and a wide side 12g, where a first end edge junction box 15g, a second end edge junction box 16g, and an intermediate junction box 17g located between the first end edge junction box 15g and the second end edge junction box 16g are arranged on surfaces facing away from light at two ends along a center line of the long side 11g of the photovoltaic module respectively, and the junction boxes 15g, 16g, 17g are located on the same side of the long side 11g.

Embodiments 1-7 inventively provide that the end edge junction boxes are arranged on the same side of light-facing surfaces or the surfaces facing away from light at the two ends along the center line of the long side of the photovoltaic module, the end edge junction boxes are electrically connected by means of bus bars known from the photovoltaic modules, and it is only necessary to electrically connect the end edge junction boxes to the end edge junction boxes of other photovoltaic modules by means of cable connectors, such that usage amount of the cables for electric connection between the junction boxes can be greatly reduced. After a plurality of photovoltaic modules are connected in series or in parallel to form a photovoltaic array structure, the present invention can obviously shorten a thread of a direct current cable in the photovoltaic array structure, and reduce line loss inside the photovoltaic array structure. Embodiments 1 and 4-7 further preferably provide that one or more intermediate junction boxes are arranged between the end edge junction boxes, and the intermediate junction box may serve as a bypass protection structure for a photovoltaic cell string, and may further satisfy a photovoltaic module structure having a large spacing between the first end edge junction box and the second end edge junction box, such that the present application can have better commonality and universality during implementation.

**Embodiment 8:** With reference to FIG. 8 in combination with FIG. 11, a color steel tile 20a for mounting a photovoltaic module is provided. Preferably, in this implementation, the color steel tile 20a is formed by integrated stamping, integrated die-casting or integrated extrusion, steel, aluminum, other suitable metal alloys (such as aluminum magnesium manganese alloy plates) or plastic materials may be used as materials, the steel and aluminum alloys are used as more preferred solutions, and an integrated structure is used, such that mounting strength can be ensured, and a mounting procedure can be simplified. It should be noted that the color steel tile involved in full text of the present application is a general term in the field of photovoltaic module mounting and does not have particular material limitations.

Preferably, in this implementation, the color steel tile 20a includes a color steel tile substrate 20a', where a protective clamping edge 21a is arranged on one side of the color steel tile substrate 20a', a clamping edge 22a is arranged on the other side of the color steel tile substrate, and the protective clamping edge 21a includes a clamping portion 24a located on an inner side and a protective cover 25a located on an outer side.

During mounting and use, the photovoltaic module of one of Embodiments 1-7 (FIG. 11 shows a photovoltaic module 10d) may be fixedly mounted in a limiting groove 23a formed between the protective clamping edge 21a and the clamping edge 22a. The clamping portion 24a of the protective clamping edge 21a matches the clamping edge 22a of the color steel tile 20a adjacent to the clamping portion in a clamped manner, the clamping edge 22a matches the clamping portion 24a of the color steel tile 20a adjacent to the clamping edge in a clamped manner, and the protective cover 25a is located above one side of the photovoltaic module corresponding to the protective cover and is used for shielding and protection.

Specifically preferably, in the implementation, the clamping portion 24a is in a shape of a bent protrusion, such that clamping strength is ensured, clamping is facilitated, and a height range of the clamping portion 24a is 10 mm to 50 mm. The protective cover 25a is fixedly connected to the clamping portion 24a and includes a cover protection plate 26a and a side protection plate 27a that are connected in a bent manner. Preferably, in this implementation, the cover protection plate 26a has a height less than that of the clamping portion 24a, which may facilitate clamping, and moreover, the height of the cover protection plate 26a is lower such that a better shielding effect can be achieved. The cover protection plate 26a and the photovoltaic module are arranged in parallel, and the side protection plate 27a is inclined along the other side of the photovoltaic module 10d corresponding to the side protection plate, and is used for increasing an area for shielding and protection on one side of the photovoltaic module 10d, such that a better shielding and protection effect on a side edge of the photovoltaic module 10d located below the side protection plate can be improved.

During subsequent further practical application of Embodiment 8, the protective cover 25a may be arranged above each junction box on one side of any of the photovoltaic modules of Embodiments 1-7 to directly shield and protect each junction box of the photovoltaic module of Embodiments 1-7, so as to effectively shield and protect each junction box and ensure service life of each junction box.

**Embodiment 9:** Remaining technical solutions of Embodiment 9 are the same as those of Embodiment 8, and the differences lie in that in Embodiment 9, with reference to FIG. 9 in combination with a color steel tile for mounting a photovoltaic module as shown in FIG. 12, the color steel tile includes a first color steel tile 20b and a second color steel tile 20c, where one side of the first color steel tile 20b is provided with a protective clamping edge 21b (equivalent to a second clamping edge); one side of the second color steel tile 20c is provided with a first clamping edge 21c; the protective clamping edge 21b of the first color steel tile 20b matches the first clamping edge 21c of the second color steel tile 20c adjacent to the protective clamping edge in a clamped manner, and correspondingly matches the second color steel tile 20c opposite the protective clamping edge to form a limiting hollowed-out groove 20d for fixedly mounting the photovoltaic module (FIG. 12 shows a photovoltaic module 10d), and the protective clamping edge 21b includes a clamping portion 22b located on an inner side and a protective cover 23b located on an outer side, where the clamping portion 22b matches the first clamping edge 21c of the second color steel tile 20c adjacent to the clamping portion in a clamped manner, and the protective cover 23b is located above one side of the photovoltaic module 10d corresponding to the protective cover and is used for shielding and protection.

During practical application of Embodiment 9, the protective cover 23b may also be arranged above each junction box on one side of the photovoltaic module of any one of Embodiments 1-7 to directly shield and protect each junction box of the photovoltaic module, so as to effectively shield and protect each junction box and ensure service life of each junction box. With structure design of the limiting hollowed-out groove 20d in this embodiment, conventional contact between the color steel tile and a mounting base surface is directly replaced with a back surface of the photovoltaic module, such that usage amount of materials for the color steel tile is obviously reduced, manufacturing costs are effectively reduced, and the mounting weight of the color steel tile is reduced. The color steel tile can be mounted in combination with various specifications of photovoltaic modules without being limited by a size of a wide side of the photovoltaic module, such that commonality is excellent.

**Embodiment 10:** With reference to contents as shown in FIG. 8 and FIG. 4, an integrated assembly 30a of photovoltaic color steel tiles shown in FIG. 10 and FIG. 11 includes a color steel tile 20a in Embodiment 8 and a photovoltaic module 10d in Embodiment 4. The color steel tile 20a includes a color steel tile substrate 20a', and both sides of the color steel tile substrate 20a' are respectively provided with a first clamping edge 22a and a second clamping edge. The photovoltaic module 10d is fixedly mounted in a limiting groove 23a formed between the first clamping edge 22a and the second clamping edge; and the second clamping edge matches the first clamping edge 22a of the color steel tile 20a adjacent to the second clamping edge in a clamped manner, and the first clamping edge 22a matches the second clamping edge of the color steel tile 20a adjacent to the first clamping edge in a clamped manner. The second clamping edge uses a protective clamping edge 21a, and the protective clamping edge 21a includes a clamping portion 24a located at an inner side and a protective cover 25a located at an outer side. The protective cover 25a is fixedly connected to the clamping portion 24a, and includes a cover protection plate 26a and a side protection plate 27a that are connected in a bent manner.

Preferably, in this implementation, the photovoltaic module 10d includes a crystalline silicon cell string layer located in a middle, and a front package layer and a back package layer that are used for packaging the crystalline silicon cell string layer respectively. The back package layer is attached to the color steel tile substrate 20a', and is directly attached to the color steel tile substrate 20a' by means of an adhesive tape, an adhesive or a thermo-plastic adhesive film. Specifically preferably, in this implementation, the front package layer and the back package layer each include a flexible composite film layer, where the flexible composite film layer has weight not exceeding 2 kg/cm². Specific preferred material solutions for the flexible composite film layer may directly refer to 201610685536.0; and the technical solution described in 201610685240.9 has an excellent lightweight flexible effect.

In this implementation, the protective cover 25a is located above one side of the photovoltaic module 10d corresponding to the protective cover, and is used for shielding and protecting each junction box 14a, 15d, 16d. The cover protection plate 26a is mainly used for shielding an upper portion, the side protection plate 27a is mainly used for shielding an outer side, and moreover, the clamping portion 24a located on the inner side is used as a protection structure. With the structure, an excellent protective effect of the junction boxes 14a, 15d, 16d located on one side of light-facing surfaces of the photovoltaic module 10d is achieved at the same time.

In this embodiment, the color steel tile substrates 20a' of the clamping edges 21a, 22a are arranged on two sides of the integrated assembly of the photovoltaic color steel tiles, and the photovoltaic module 10d is arranged in the limiting groove 23a between the clamping edges 21a, 22a, such that it is advantageous to rapidly position and mount the photovoltaic module 10d. Moreover, during practical application, a mounting procedure of the integrated assembly 30a of the photovoltaic color steel tiles provided in this embodiment may be directly completed in a factory, such that a mounting workload during subsequent application of a photovoltaic mounting system is greatly reduced.

Those skilled in the art may integrate and mount the color steel tile 20a and other structures or shapes (such as photovoltaic modules in Embodiments 1-3 and 5-7) of photovoltaic modules as required to obtain other integrated assemblies of photovoltaic color steel tiles, which are all equivalent replacements of this embodiment.

**Embodiment 11:** With reference to contents as shown FIG. 9 and FIG. 4, an integrated assembly 30b of photovoltaic color steel tiles as shown in FIG. 10 and FIG. 12 includes a color steel tile in Embodiment 9 and a photovoltaic module 10d in Embodiment 4. The color steel tile includes a first color steel tile 20b and a second color steel tile 20c. One side of the first color steel tile 20b is provided with a protective clamping edge 21b (which is a second clamping edge), and the protective clamping edge 21b includes a clamping portion 22b located on an inner side and a protective cover 23b located on an outer side. One side of the second color steel tile is provided with a first clamping edge 21c. The clamping portion 22b of the first color steel tile 20b matches the first clamping edge 21c of the second color steel tile 20c adjacent to the clamping portion in a clamped manner, and correspondingly matches the second color steel tile 20c corresponding to the clamping portion, to form a limiting hollowed-out groove 20d for fixedly mounting one or more photovoltaic modules 10d. The photovoltaic module 10d is fixedly mounted in the limiting hollowed-out groove 20d. It should be noted that in order to facilitate subsequent clamping mounting of a photovoltaic mounting system in batches, a blank mounting region is arranged at one end of the photovoltaic module 10d and is used for placing the photovoltaic module 10d clamped to the blank mounting region, and due to structural design of the limiting hollowed-out groove 20d provided in this embodiment, during practical application, one end of the limiting hollowed-out groove 20d is usually attached in a bonded manner to be used as a cover plate 20e of the blank mounting region (see FIG. 10).

The technical solution of the photovoltaic module 10d of Embodiment 11 is the same as that of Embodiment 10, and mounting weight of the photovoltaic module 10d usually does not exceed 6 kg/m²; and a back package layer of the photovoltaic module 10d is attached in the limiting hollowed-out groove 20d.

In this implementation, the protective cover 23b is located above one side of the photovoltaic module 10d corresponding to the protective cover, and is used for shielding and protecting each junction box 14a, 15d, 16d. A cover protection plate 24b of the protective cover 23b is mainly used for shielding an upper portion, a side protection plate 25b of the protective cover 23b is mainly used for shielding an outer side, and the clamping portion 22b located on the inner side is used as a protection structure. With the structure, an excellent protective effect of the junction boxes 14a, 15d, 16d located on one side of a light-facing surface of the photovoltaic module 10d is achieved at the same time.

Embodiment 11 inventively provides the first color steel tile 20b having the protective clamping edge 21b and the second color steel tile 20c having the first clamping edge 21c. The first color steel tile 20b and the second color steel tile 20c are oppositely arranged to form the limiting hollowed-out groove for fixedly mounting the photovoltaic module. During practical application and mounting, conventional contact between the color steel tile and the mounting base surface is directly replaced with a back surface of the photovoltaic module, such that usage amount of materials for the color steel tiles 20b, 20c is obviously reduced, manufacturing costs are effectively reduced, and overall mounting weight of the integrated assembly 30b of the photovoltaic color steel tiles is significantly reduced. Moreover, the hollowed-out integrated assembly 30b of the photovoltaic color steel tiles provided in this embodiment is further extremely convenient to mount and maintain subsequently, and may be widely applied in mounting environments having different mounting characteristics, including being extremely suitable for being directly mounted and used on waste color steel tile building roofs, such that a mounting procedure is greatly simplified while mounting strength is ensured.

Those skilled in the art may integrate and mount the color steel tiles 20b, 20c and other structures or shapes (such as photovoltaic modules in Embodiments 1-3 and 5-7) of photovoltaic modules as required to obtain other integrated assemblies of photovoltaic color steel tiles, which are all equivalent replacements of this embodiment.

Embodiment 11 further provides a method for mounting the above integrated assembly 30b of the photovoltaic color steel tiles. The method includes:
S10) place the integrated assembly 30b of the photovoltaic color steel tiles on a mounting base surface, and make a back package layer of a photovoltaic module 10d in direct contact with the mounting base surface;
S20) make a first color steel tile 20b of the integrated assembly 30b of the photovoltaic color steel tiles match a second color steel tile 20c of an integrated assembly of photovoltaic color steel tiles adjacent to the first color steel tile in a clamped manner, and make a second color steel tile 20c of the integrated assembly 30b of the photovoltaic color steel tiles match a first color steel tile 20b of the integrated assembly of the photovoltaic color steel tiles adjacent to the second color steel tile in a clamped manner, where specifically preferably, the color steel tiles 20b, 20c are mounted and locked on the mounting base surface by means of fasteners, and the fastener may take the form of a hidden fastener; and
S30) distribute a plurality of integrated assemblies 30b of photovoltaic color steel tiles in an array structure, and connect the integrated assemblies 30b of photovoltaic color steel tiles in series and/or in parallel, which may be specifically arranged according to wiring requirements and mounting requirements, and is not particularly limited in this embodiment.

**Embodiment 12:** With reference to FIG. 13 and FIG. 14, a photovoltaic mounting system includes an A-type photovoltaic module column 1a formed by connecting at least two A-type photovoltaic modules 1a' in series and a B-type photovoltaic module column 1b by connecting at least 2 B-type photovoltaic modules 1b' in series, where the A-type photovoltaic module column 1a and the B-type photovoltaic module column 1b are connected in series and are arranged on a mounting base surface by using alternating structures arranged in parallel. Preferably, in this implementation, the mounting base surface uses a building roof 2, several purlines 3 are mounted on the building roof 2 in a spaced manner, and the A-type photovoltaic module column 1a and B-type photovoltaic module column 1b are fixedly mounted on the purlines 3. Specifically preferably, with reference to FIG. 15 and FIG. 16, in this implementation, structures of the A-type photovoltaic module 1a' the B-type photovoltaic module 1b' each use a 2-series 1/2 slice type photovoltaic module 10a in Embodiment 1, but an electrode output structure is configured in an opposite structure, which are all conventional technical means that may be made by those skilled in the art on the basis of technical contents of the present application and contents shown in the figures. Therefore, a specific electrode structure of the photovoltaic module 10a is not described with specific text in detail in this embodiment. Moreover, during practical mounting, the 2-series 1/2 slice type photovoltaic module 10a uses the solution of an integrated assembly 30b of photovoltaic color steel tiles in Embodiment 11 (in other implementations, the 2-series 1/2 slice type photovoltaic module may also use the solution of an integrated assembly 30a of photovoltaic color steel tiles in Embodiment 10), such that a convenient and rapid effect is facilitated for mounting in batches, and the color steel tiles in each integrated assembly of the photovoltaic color steel tiles are fixedly mounted on the purline 3 by means of fastening screws (not shown in the figures).

The A-type photovoltaic module column 1a includes an A-type positive output terminal 2a located at one end and an A-type negative output terminal 3a located at the other end; the B-type photovoltaic module column 1b includes a B-type positive output terminal 2b located at one end and a B-type negative output terminal 3b located at the other end; the A-type positive output terminal 2a is located at the same end as the B-type negative output terminal 3b, and the A-type negative output terminal 3a is located at the same end as the B-type positive output terminal 2b. The A-type negative output terminal 3a is electrically connected to the B-type positive output terminal 2b of the B-type photovoltaic module column 1b adjacent to the A-type negative output terminal by means of a cable connector 21, and the A-type positive output terminal 2a and the B-type negative output terminal 3b may be directly converged into a combiner box, and may be connected in series for wiring by means of an upper cornice (well-known structure). It should be noted that in this implementation, the A-type photovoltaic module 1a' or the B-type photovoltaic module 1b' located at two ends each includes a first end edge junction box 15a and a second end edge junction box 16a, where output ends of the first end edge junction box 15a and the second end edge junction box 16a serve as the positive output terminals 2a, 2b and the negative output terminals 3a, 3b of the photovoltaic module columns 1a, 1b corresponding to the output ends. There are all technical contents that may be unambiguously obtained in the art on the basis of technical contents described in the present application, and will not be repeated in this embodiment in order to save a description space.

Preferably, in this implementation, the junction boxes 15a, 16a, 17a of the A-type photovoltaic module 1a' and the junction boxes 15a, 16a, 17a of the B-type photovoltaic module 1b' are located on the same side (shown in FIG. 13), and are embodied in a spaced parallel shape. With reference to the solution as shown in Embodiment 15, the B-type photovoltaic module may also be the A-type photovoltaic module after 180-degree planar rotation, and the junction box of the A-type photovoltaic module and the junction box of the B-type photovoltaic module are located on different sides to form a single-set double-row docking box structure.

Preferably, in this implementation, a cable between the A-type negative output terminal 3a and the B-type positive output terminal 2b is sleeved with a soft metal tube (not shown in the figures) for avoiding contact between the cable and the building roof 2. The building roof 2 includes a ridge bridge 4 (which is provided with a bridge cover plate) for wiring the A-type positive output terminal 2a and the B-type negative output terminal 3b, and the A-type positive output terminal 2a and the B-type negative output terminal 3b are converged into the combiner box (not shown in the figures) by means of the ridge bridge 4. In this implementation, electric connection between the A-type negative output terminal 3a and the B-type positive output terminal 2b of the B-type photovoltaic module column 1b adjacent to the A-type negative output terminal is wired by means of a lower cornice (well-known structure) of the building roof 2.

Embodiment 12 inventively provides the photovoltaic mounting system formed by connecting the A-type photovoltaic module column 1a and the B-type photovoltaic module column 1b in series and using alternating structures arranged in parallel. The negative output terminal 3b of the B-type photovoltaic module column 1b is located at the same end as the positive output terminal 2a of the A-type photovoltaic module column 1a, the positive output terminal 2b of the B-type photovoltaic module column 1b is located at the same end as the negative output terminal 3a of the A-type photovoltaic module column 1a. Under this particular structure, it is ensured that the thread of the direct current cable between the negative output terminal 3a of the A-type photovoltaic module column 1a and the positive output terminal 2b of the B-type photovoltaic module column 1b is considerably shortened, such that a wiring structure of the thread of the long direct current cable is effectively avoided, and line loss of the photovoltaic mounting system is obviously reduced.

**Embodiment 13:** Remaining technical solutions of Embodiment 13 are the same as those of Embodiment 12, and the differences lie in that with reference to FIG. 17, FIG. 18 and FIG. 19, in Embodiment 13, a 5-series 1/2 slice type photovoltaic module 10d in Embodiment 4 is used as structures of an A-type photovoltaic module 1a' and a B-type photovoltaic module 1b', but there are also differences in an electrode output structure (shown in FIG. 18 and FIG. 19). Moreover, during practical mounting, the 5-series 1/2 slice type photovoltaic module 10d uses the solution of an integrated assembly 30a of photovoltaic color steel tiles in Embodiment 10 (of course, the 5-series 1/2 slice type photovoltaic module may also use the solution of an integrated assembly 30b of photovoltaic color steel tiles in Embodiment 11), such that a convenient and rapid effect is facilitated for mounting in batches. Electric connection between an A-type negative output terminal of an A-type photovoltaic module column 1a and a B-type positive output terminal 2b of a B-type photovoltaic module column 1b adjacent to the A-type negative output terminal is wired by means of a lower cornice 5 of a building roof 2.

**Embodiment 14:** With reference to FIG. 17, FIG. 18 and FIG. 19, the technical solution of a photovoltaic mounting system of Embodiment 14 is the same as that of Embodiment 13, and the differences lie in that with reference to FIG. 20, Embodiment 14 provides a wiring structure for a photovoltaic mounting system, and the technical solution used includes: electric connection between an A-type negative output terminal and a B-type positive output terminal is wired by means of a perforation. Preferably, in this implementation, each photovoltaic module is provided with a negative output terminal perforation and a positive output terminal perforation, and a cable between the A-type negative output terminal and the B-type positive output terminal passes through the negative output terminal perforation and passes out of the positive output terminal perforation.

Same as Embodiment 13, an A-type photovoltaic module 1a' and a B-type photovoltaic module 1b' in Embodiment 14 both use a 5-series 1/2 slice type photovoltaic module 10d in Embodiment 4. Further preferably, during practical mounting of this embodiment, the 5-series 1/2 slice type photovoltaic module 10d uses an integrated assembly 30a of photovoltaic color steel tiles in Embodiment 10. In this implementation, a color steel tile 20a of the A-type photovoltaic module 1a' is provided with a negative output terminal perforation 6a, and a color steel tile 20a of the B-type photovoltaic module 1b' is provided with a positive output terminal perforation 6b.

Specifically preferably, in this implementation, the cable is sleeved with a soft metal tube (not shown in the figures), such that contact between the cable and a building roof 2 is avoided, and mounting safety is ensured; and the negative output terminal perforation 6a and the positive output terminal perforation 6b are sleeved with soft water-proof seals (not shown in the figures). Specifically preferably, the soft water-proof seal uses a rubber material which may be directly commercially available, and for example, specifically, a perfect grade (PG) series of water-proof plug may be used.

In other implementations of this embodiment, the 5-series 1/2 slice type photovoltaic module 10d uses an integrated assembly of photovoltaic color steel tiles in Embodiment 11, a negative output terminal perforation is provided on a color steel tile of an A-type photovoltaic module 1a', and a positive output terminal perforation is provided on a color steel tile of a B-type photovoltaic module 1b'.

On the basis of Embodiment 13, Embodiment 14 further uses a perforated wiring structure for electric connection between a negative output terminal of an A-type photovoltaic module column 1a and a positive output terminal of a B-type photovoltaic module column 1b without relying on a lower cornice wiring structure in Embodiment 13, such that the thread of the direct current cable is greatly shortened, and line loss is further reduced, and the perforated wiring structure is simple and convenient to implement.

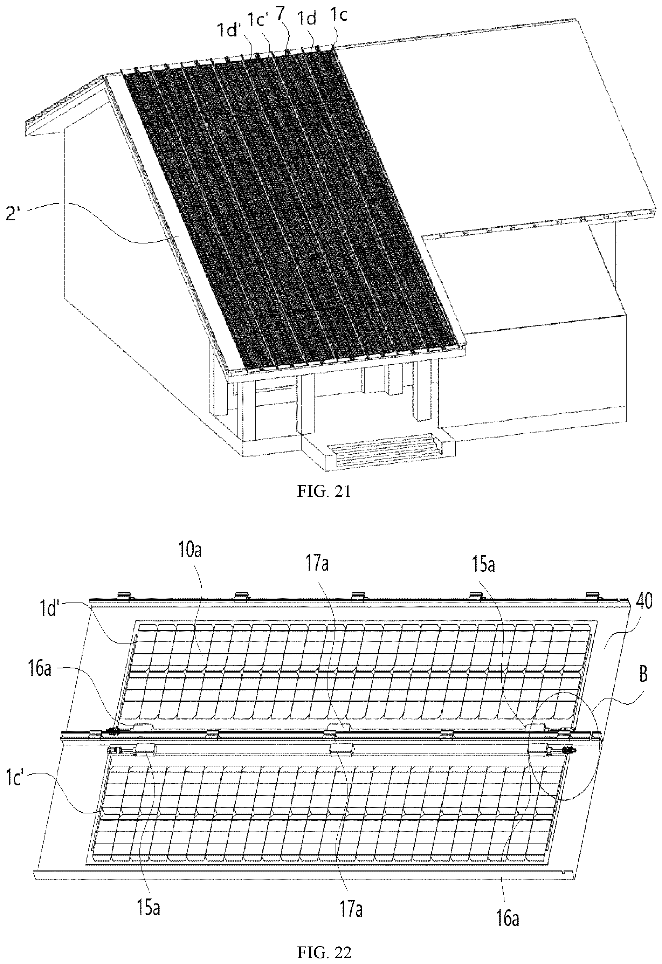

**Embodiment 15:** Remaining technical solutions of a photovoltaic mounting system of Embodiment 15 are the same as that of Embodiment 12, and the differences lie in that in Embodiment 15, a photovoltaic mounting system having low line loss as shown in FIG. 21 includes an A-type photovoltaic module column 1c formed by connecting at least two A-type photovoltaic modules 1c' in series and a B-type photovoltaic module column 1d formed by connecting at least two B-type photovoltaic modules 1d' in series. The A-type photovoltaic module column 1c and the B-type photovoltaic module column 1d are connected in series and are arranged on a mounting base surface by using alternating structures arranged in parallel, and the mounting base surface includes a building roof, a carport roof or a ground. Specifically preferably, in this implementation, the mounting base surface is also a building roof 2'.

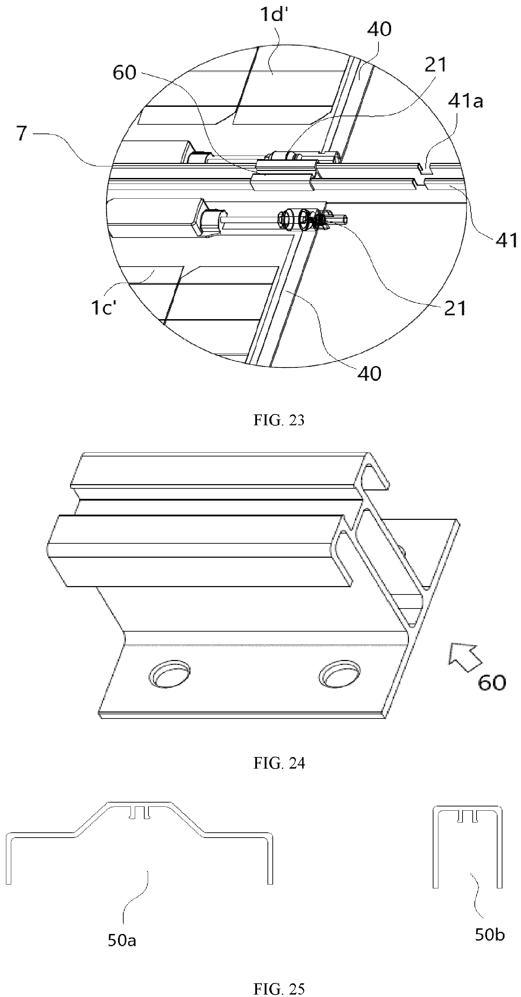

Further, with reference to FIG. 22 and FIG. 23, in this implementation, the A-type photovoltaic module 1c' also uses a 2-series 1/2 slice type photovoltaic modules 10a in Embodiment 1, and the B-type photovoltaic module 1d' is the A-type photovoltaic module 1c' after 180-degree planar rotation, such that junction boxes 15a, 16a, 17a of the A-type photovoltaic module 1c' and junction boxes 15a, 16a, 17a of the B-type photovoltaic module adjacent to the A-type photovoltaic module are adjacently arranged (which are located on different sides) to form a single-set double-row docking box 7 structure.

Preferably, in this implementation, each photovoltaic module 1c', 1d' is mounted on a color steel tile 40, and every two adjacent color steel tiles 40 are fixedly mounted and connected into a whole. With reference to FIG. 24 and FIG. 25, a junction box cover 50a is mounted on the color steel tile 40, and the junction box cover 50a is located above a single-set double-row docking box 7 structure and is used for shielding and protection; and every two adjacent color steel tiles 40 are fixedly connected into a whole by means of a hidden mounting seat 60. Further preferably, in this implementation, clamping edges 41 are arranged on two sides of the color steel tile 40 respectively, and the hidden mounting seat 60 is located between every two adjacent color steel tiles 40 and is clamped to the clamping edges 41 of the color steel tiles 40 located two sides of the hidden mounting seat separately; and the hidden mounting seat 60 is fixedly mounted on the building roof 2'.

Preferably, in this implementation, a line groove 41 is provided on the clamping edge 41 of the color steel tile 40, electric connection between an A-type negative output terminal 3a and a B-type positive output terminal 2b is wired by means of the line groove 41a and a cable connector 21. Junction box edge cover plates 50b are arranged above the junction boxes 15a, 16a, 17a of the A-type photovoltaic module 1c' located on one side or the junction boxes 15a, 16a, 17a of the B-type photovoltaic module located on one side, and the junction box edge cover plates 50b are mounted on the color steel tiles 40 corresponding to the junction box edge cover plates to separately shield and protect junction boxes that are located on a side surface and do not constitute the single-set double-row docking box 7 structure.

Embodiment 15 provides the photovoltaic mounting system having low line loss, which is formed by connecting the A-type photovoltaic modules 1c' and the A-type photovoltaic modules 1c' (which serve as the B-type photovoltaic modules 1d') after 180-degree planar rotation in series and uses alternating structures arranged in parallel, and it is unnecessary to specially arrange two models of photovoltaic modules, such that a production procedure of the photovoltaic module is simplified, and management during mass production is facilitated. It is only necessary for the present application to perform alternating 180-degree planar rotation on the A-type photovoltaic module 1c' during system mounting, and the single-set double-row docking box structure is formed by means of the particular structure, such that it is ensured that the thread of the direct current cable between the negative output terminal 3a of the A-type photovoltaic module column 1c and the positive output terminal 2b of the B-type photovoltaic module column 1d is shortened to the greatest extent, line loss is reduced to the greatest extent, and an excellent level of line management is achieved.

It is obvious to those skilled in the art that the present invention is not limited to the details of the above exemplary embodiments, and the present invention may be implemented in other specific forms without departing from the essential features of the present invention. Therefore, the embodiments should be regarded in all respects as exemplary rather than as restrictive, and the scope of the present invention is defined by the appended claims rather than the above descriptions. Therefore, all changes falling within the meanings and scope of the claims fall within the present invention. Any reference numeral in the claims shall not be construed as limiting the related claims.

In addition, it should be understood that, although the description has been described with reference to implementations, not every implementation includes only one independent technical solution, and such description of the description is by way of clarity only. Those skilled in the art should take the description as a whole, and the technical solutions of the embodiments may be combined as appropriate to form other implementations that may be understood by those skilled in the art.

## Claims

1. A photovoltaic array structure having low line loss, comprising several photovoltaic modules (10a) as photovoltaic array units, wherein each photovoltaic module comprises one photovoltaic cell string (13a) or a plurality of photovoltaic cell strings distributed row by row or column by column and connected in series and/or in parallel, and the photovoltaic module comprises a long side (11a) and a short side (12a), a first end edge junction box (15a) and a second end edge junction box (16a) being arranged on light-facing surfaces or surfaces facing away from light at two ends along a center line of the long side of the photovoltaic module respectively, and
being located on the same side of the long side of the photovoltaic module, the junction boxes being electrically connected by means of bus bars, and
the first end edge junction box and/or the second end edge junction box being electrically connected to end edge junction boxes of the photovoltaic module adjacent to the first end edge junction box and/or the second end edge junction box by means of cable connectors (21) respectively,
**characterized in that** said photovoltaic array structure further comprises an A-type photovoltaic module column (1a) formed by connecting at least two A-type photovoltaic modules (1a') in series and a B-type photovoltaic module column (1b) formed by connecting at least two B-type photovoltaic modules (1b') in series, the A-type photovoltaic module column and the B-type photovoltaic module column being connected to each other in series and arranged on a mounting base surface by using alternating structures arranged in parallel;
wherein the A-type photovoltaic module column (1a) comprising an A-type positive output terminal (2a) located at one end and an A-type negative output terminal (3a) located at the other end;
the B-type photovoltaic module column (1b) comprising a B-type positive output terminal (2b) located at one end and a B-type negative output terminal (3b) located at the other end;
the A-type positive output terminal (2a) being located at the same end as the B-type negative output terminal (3b), and the A-type negative output terminal (3a) being located at the same end as the B-type positive output terminal (2b); and
the A-type negative output terminal (3a) being electrically connected to the B-type positive output terminal (2b) of the B-type photovoltaic module column (1b) adjacent to the A-type negative output terminal by means of the cable connector.

2. The photovoltaic array structure having low line loss according to claim 1, wherein a spacing between the first end edge junction box and the second end edge junction box is not less than 200 mm.

3. The photovoltaic array structure having low line loss according to claim 1, wherein the photovoltaic module comprises at least one intermediate junction box located between the first end edge junction box and the second end edge junction box, the junction boxes being located on the same side of the long side, at least one diode being arranged in the at least one junction box, and the diode being inversely connected in parallel between a positive electrode and a negative electrode of the photovoltaic cell string corresponding to the diode, and being used for bypass protection.

4. The photovoltaic array structure having low line loss according to claim 3, wherein a spacing range between the first end edge junction box and the second end edge junction box is 500 mm to 2000 mm.

5. The photovoltaic array structure having low line loss according to claim 1, 2, 3 or 4, wherein each photovoltaic module comprises at least two photovoltaic cell strings, each photovoltaic cell string comprising at least two cell pieces (14a) connected in series or connected in series in a laminated manner, the cell piece using an entire piece or a slice, and being a crystalline silicon wafer, and the full cell piece having a single-side length ranging from 100 mm to 260 mm.

6. The photovoltaic array structure having low line loss according to claim 5, wherein a package layer of the photovoltaic module comprises a flexible composite film layer and/or a glass layer.

7. The photovoltaic array structure having low line loss according to claim 5, wherein the diode is arranged in each junction box, the plurality of photovoltaic cell strings distributed row by row or column by column and connected in series and/or in parallel are distributed in a direction of the long side, a single diode is inversely connected in parallel between the positive electrode and the negative electrode of the at least two photovoltaic cell strings distributed row by row or column by column, and the diodes are connected in series and are used for bypass protection of the photovoltaic cell strings corresponding to the diodes.

8. The photovoltaic array structure having low line loss according to claim 7, wherein 6n photovoltaic cell strings distributed column by column and connected in series and/or in parallel are distributed on the long side, and a single diode is inversely connected in parallel between the positive electrode and the negative electrode of every 2n photovoltaic cell strings distributed column by column, n being a positive integer equal to or greater than 1.

9. The photovoltaic array structure having low line loss according to claim 7, wherein at least two photovoltaic cell strings distributed row by row, connected in parallel and comprising 6n cell pieces are distributed on the long side, and a single diode is inversely connected in parallel between the positive electrode and the negative electrode of every 2n, 3n, or 6n cell pieces in each row, n being a positive integer equal to or greater than 1.

10. The photovoltaic array structure having low line loss according to claim 1, wherein the photovoltaic module uses an integrated assembly of photovoltaic color steel tiles.

11. The photovoltaic array structure having low line loss according to claim 1, wherein the photovoltaic module uses a laminated lightweight flexible crystalline silicon photovoltaic module, comprising a front package layer, a laminated crystalline silicon photovoltaic cell string, and a back package layer that are laminated and packaged into a whole, the front package layer and the back package layer each comprising a flexible composite film layer, and the flexible composite film layer having weight not exceeding 2 kg/cm²; the laminated lightweight flexible crystalline silicon photovoltaic module comprises a long side and a wide side, a first end edge junction box and a second end edge junction box being arranged on light-facing surfaces or surfaces facing away from light at two ends along a center line of the long side of the photovoltaic module respectively, and being located on the same side of the long side of the photovoltaic module, the junction boxes being electrically connected by means of bus bars, and the first end edge junction box and/or the second end edge junction box being electrically connected to end edge junction boxes of the photovoltaic module adjacent to the he first end edge junction box and/or the second end edge junction box by means of cable connectors respectively.

12. The photovoltaic array structure having low line loss according to claim 11, wherein the flexible composite film layer uses a composite fiber cloth of a thermosetting powder coating.

13. The photovoltaic array structure having low line loss according to claim 12, wherein the thermosetting powder coating uses an acrylic thermosetting powder coating or a polyester thermosetting powder coating.

14. The photovoltaic array structure having low line loss according to claim 11, wherein a packaging adhesive film layer is arranged between the front package layer and the laminated crystalline silicon photovoltaic cell string.

## Patentansprüche

1. Photovoltaische Array-Struktur mit geringem Leitungsverlust, die mehrere photovoltaische Module (10a) als photovoltaische Array-Einheiten umfasst, wobei jedes photovoltaische Modul einen photovoltaischen Zellstrang (13a) oder eine Vielzahl von photovoltaischen Zellsträngen umfasst, die zeilenweise oder spaltenweise verteilt und in Reihe und/oder parallel geschaltet sind, und das Photovoltaikmodul eine lange Seite (11a) und eine kurze Seite (12a) umfasst, wobei eine erste Endkantenanschlussdose (15a) und eine zweite Endkantenanschlussdose (16a) an lichtzugewandten oder lichtabgewandten Oberflächen an zwei Enden entlang einer Mittellinie der langen Seite des Photovoltaikmoduls angeordnet sind, und
auf der gleichen Seite der Längsseite des Photovoltaikmoduls angeordnet sind, wobei die Anschlussdosen mittels Stromschienen elektrisch verbunden sind, und
der erste Endkantenanschlusskasten und/oder der zweite Endkantenanschlusskasten elektrisch mit Endkantenanschlusskästen des Photovoltaikmoduls, die dem ersten Endkantenanschlusskasten und/oder dem zweiten Endkantenanschlusskasten benachbart sind, mittels Kabelverbindern (21) verbunden sind,
**dadurch gekennzeichnet, dass** die Photovoltaik-Anordnungsstruktur ferner eine Photovoltaik-Modul-Säule (1a) des A-Typs, die durch Reihenschaltung von mindestens zwei Photovoltaik-Modulen (1a') des A-Typs gebildet wird, und eine Photovoltaik-Modul-Säule (1b) des B-Typs, die durch Reihenschaltung von mindestens zwei Photovoltaik-Modulen (1b') des B-Typs gebildet wird, umfasst, wobei die Photovoltaik-Modul-Säule des A-Typs und die Photovoltaik-Modul-Säule des B-Typs miteinander in Reihe geschaltet sind und auf einer Montagegrundfläche unter Verwendung abwechselnd parallel angeordneter Strukturen angeordnet sind;
wobei die Säule (1a) des A-Typ-Photovoltaikmoduls einen positiven Ausgangsanschluss (2a) des A-Typs, der sich an einem Ende befindet, und einen negativen Ausgangsanschluss (3a) des A-Typs, der sich an dem anderen Ende befindet, umfasst;
die Säule (1b) des B-Typ-Photovoltaikmoduls einen positiven Ausgangsanschluss (2b) des B-Typs, der sich an einem Ende befindet, und einen negativen Ausgangsanschluss (3b) des B-Typs, der sich am anderen Ende befindet, umfasst;
wobei der positive Ausgangsanschluss (2a) des A-Typs an demselben Ende wie der negative Ausgangsanschluss (3b) des B-Typs angeordnet ist, und der negative Ausgangsanschluss (3a) des A-Typs an demselben Ende wie der positive Ausgangsanschluss (2b) des B-Typs angeordnet ist; und
wobei der negative Ausgangsanschluss (3a) des A-Typs mit dem positiven Ausgangsanschluss (2b) des B-Typs der Säule (1b) des photovoltaischen Moduls neben dem negativen Ausgangsanschluss des A-Typs mittels des Kabelverbinders elektrisch verbunden ist.

2. Photovoltaik-Array-Struktur mit geringem Leitungsverlust nach Anspruch 1, wobei ein Abstand zwischen der ersten Endrand-Anschlussdose und der zweiten Endrand-Anschlussdose nicht weniger als 200 mm beträgt.

3. Photovoltaik-Anordnungsstruktur mit geringem Leitungsverlust nach Anspruch 1, wobei das Photovoltaik-Modul mindestens eine Zwischenverbindungsdose umfasst, die sich zwischen der ersten Endkantenverbindungsdose und der zweiten Endkantenverbindungsdose befindet, wobei sich die Verbindungsdosen auf derselben Seite der langen Seite befinden, wobei mindestens eine Diode in der mindestens einen Verbindungsdose angeordnet ist und die Diode umgekehrt parallel zwischen einer positiven Elektrode und einer negativen Elektrode des der Diode entsprechenden Photovoltaik-Zellenstrangs geschaltet ist und zum Bypass-Schutz verwendet wird.

4. Fotovoltaik-Array-Struktur mit geringem Leitungsverlust nach Anspruch 3, wobei der Abstand zwischen dem ersten Endrand-Anschlusskasten und dem zweiten Endrand-Anschlusskasten 500 mm bis 2000 mm beträgt.

5. Die photovoltaische Array-Struktur mit geringem Leitungsverlust nach Anspruch 1, 2, 3 oder 4, wobei jedes photovoltaische Modul mindestens zwei photovoltaische Zellstrings umfasst, wobei jeder photovoltaische Zellstring mindestens zwei Zellstücke (14a) umfasst, die in Reihe geschaltet oder auf laminierte Weise in Reihe geschaltet sind, wobei das Zellstück ein ganzes Stück oder eine Scheibe verwendet und ein kristalliner Siliziumwafer ist und das volle Zellstück eine einseitige Länge im Bereich von 100 mm bis 260 mm aufweist.

6. Photovoltaische Array-Struktur mit geringem Leitungsverlust nach Anspruch 5, wobei eine Gehäuseschicht des photovoltaischen Moduls eine flexible Verbundfilmschicht und/oder eine Glasschicht umfasst.

7. Photovoltaik-Array-Struktur mit geringem Leitungsverlust nach Anspruch 5, wobei die Diode in jeder Anschlussdose angeordnet ist, die mehreren Photovoltaik-Zellenstränge, die zeilenweise oder spaltenweise verteilt und in Reihe und/oder parallel geschaltet sind, in einer Richtung der langen Seite verteilt sind, eine einzelne Diode umgekehrt parallel zwischen die positive Elektrode und die negative Elektrode der mindestens zwei Photovoltaik-Zellenstränge geschaltet ist, die zeilenweise oder spaltenweise verteilt sind, und die Dioden in Reihe geschaltet sind und für einen Bypass-Schutz der den Dioden entsprechenden Photovoltaik-Zellenstränge verwendet werden.

8. Struktur eines photovoltaischen Arrays mit geringem Leitungsverlust nach Anspruch 7, wobei 6n spaltenweise verteilte und in Reihe und/oder parallel geschaltete photovoltaische Zellstrings auf der langen Seite verteilt sind und eine einzelne Diode umgekehrt parallel zwischen der positiven Elektrode und der negativen Elektrode von jeweils 2n spaltenweise verteilten photovoltaischen Zellstrings geschaltet ist, wobei n eine positive ganze Zahl gleich oder größer als 1 ist.

9. Photovoltaische Array-Struktur mit geringem Leitungsverlust nach Anspruch 7, wobei mindestens zwei reihenweise verteilte, parallel geschaltete und 6n Zellstücke umfassende photovoltaische Zellstrings auf der Längsseite verteilt sind und eine einzelne Diode zwischen der positiven Elektrode und der negativen Elektrode von jeweils 2n, 3n oder 6n Zellstücken in jeder Reihe invers parallel geschaltet ist, wobei n eine positive ganze Zahl gleich oder größer als 1 ist.

10. Photovoltaische Array-Struktur mit geringem Leitungsverlust nach Anspruch 1, wobei das photovoltaische Modul eine integrierte Anordnung von photovoltaischen Farbstahlplatten verwendet.

11. Photovoltaik-Anordnungsstruktur mit geringem Leitungsverlust nach Anspruch 1, wobei das Photovoltaik-Modul ein laminiertes, leichtes, flexibles, kristallines Silizium-Photovoltaik-Modul verwendet, dass eine vordere Gehäuseschicht, einen laminierten, kristallinen Silizium-Photovoltaik-Zellenstrang und eine hintere Gehäuseschicht umfasst, die laminiert und zu einem Ganzen verpackt sind, wobei die vordere Gehäuseschicht und die hintere Gehäuseschicht jeweils eine flexible Verbundfolienschicht umfassen und die flexible Verbundfolienschicht ein Gewicht von nicht mehr als 2 kg/cm² aufweist; das laminierte, leichte, flexible, kristalline Silizium-Photovoltaikmodul eine lange Seite und eine breite Seite umfasst, wobei eine erste Endkanten-Anschlussdose und eine zweite Endkanten-Anschlussdose auf dem Licht zugewandten Oberflächen oder dem Licht abgewandten Oberflächen an zwei Enden entlang einer Mittellinie der langen Seite des Photovoltaikmoduls angeordnet sind und sich auf der gleichen Seite der langen Seite des Photovoltaikmoduls befinden, die Anschlusskästen mittels Stromschienen elektrisch verbunden sind und der erste Endrandanschlusskasten und/oder der zweite Endrandanschlusskasten mittels Kabelverbindern elektrisch mit Endrandanschlusskästen des Photovoltaikmoduls verbunden sind, die an den ersten Endrandanschlusskasten und/oder den zweiten Endrandanschlusskasten angrenzen.

12. Photovoltaik-Array-Struktur mit geringem Leitungsverlust nach Anspruch 11, wobei die flexible Verbundfolienschicht ein Verbundfasergewebe mit einer wärmehärtenden Pulverbeschichtung verwendet.

13. Photovoltaik-Array-Struktur mit geringem Leitungsverlust nach Anspruch 12, wobei die wärmehärtende Pulverbeschichtung eine wärmehärtende Acryl-Pulverbeschichtung oder eine wärmehärtende Polyester-Pulverbeschichtung verwendet.

14. Photovoltaik-Array-Struktur mit geringem Leitungsverlust nach Anspruch 11, wobei eine Verpackungs-Klebefilmschicht zwischen der vorderen Verpackungsschicht und dem laminierten kristallinen Silizium-Photovoltaikzellenstrang angeordnet ist.

## Revendications

1. Structure de réseau photovoltaïque à faible perte en ligne, comprenant plusieurs modules photovoltaïques (10a) en tant qu'unités de réseau photovoltaïque, dans laquelle chaque module photovoltaïque comprend une chaîne de cellules photovoltaïques (13a) ou une pluralité de chaînes de cellules photovoltaïques réparties ligne par ligne ou colonne par colonne et connectées en série et/ou en parallèle, et le module photovoltaïque comprend un grand côté (11a) et un petit côté (12a), une première boîte de jonction de bord d'extrémité (15a) et une deuxième boîte de jonction de bord d'extrémité (16a) étant disposées sur des surfaces orientées vers la lumière ou des surfaces orientées à l'opposé de la lumière à deux extrémités le long d'une ligne centrale du grand côté du module photovoltaïque respectivement, et
étant situées du même côté du côté long du module photovoltaïque, les boîtes de jonction étant connectées électriquement au moyen de barres omnibus, et
la première boîte de jonction de bord d'extrémité et/ou la deuxième boîte de jonction de bord d'extrémité sont connectées électriquement aux boîtes de jonction de bord d'extrémité du module photovoltaïque adjacentes à la première boîte de jonction de bord d'extrémité et/ou à la deuxième boîte de jonction de bord d'extrémité au moyen de connecteurs de câbles (21) respectivement,
**caractérisée par le fait que** ladite structure de réseau photovoltaïque comprend en outre une colonne de modules photovoltaïques de type A (1a) formée par la connexion en série d'au moins deux modules photovoltaïques de type A (1a') et une colonne de modules photovoltaïques de type B (1b) formée par la connexion en série d'au moins deux modules photovoltaïques de type B (1b'), la colonne de modules photovoltaïques de type A et la colonne de modules photovoltaïques de type B étant connectées l'une à l'autre en série et disposées sur une surface de base de montage à l'aide de structures alternées disposées en parallèle ;
la colonne de modules photovoltaïques de type A (1a) comprenant une borne de sortie positive de type A (2a) située à une extrémité et une borne de sortie négative de type A (3a) située à l'autre extrémité ;
la colonne de modules photovoltaïques de type B (1b) comprenant une borne de sortie positive de type B (2b) située à une extrémité et une borne de sortie négative de type B (3b) située à l'autre extrémité ;
la borne de sortie positive de type A (2a) étant située à la même extrémité que la borne de sortie négative de type B (3b), et la borne de sortie négative de type A (3a) étant située à la même extrémité que la borne de sortie positive de type B (2b) ; et
la borne de sortie négative de type A (3a) est connectée électriquement à la borne de sortie positive de type B (2b) de la colonne de modules photovoltaïques de type B (1b) adjacente à la borne de sortie négative de type A au moyen du connecteur de câble.

2. Structure de réseau photovoltaïque à faible perte de ligne selon la revendication 1, dans laquelle un espacement entre la première boîte de jonction de bord d'extrémité et la deuxième boîte de jonction de bord d'extrémité n'est pas inférieur à 200 mm.

3. Structure de réseau photovoltaïque à faible perte de ligne selon la revendication 1, dans laquelle le module photovoltaïque comprend au moins une boîte de jonction intermédiaire située entre la boîte de jonction du premier bord d'extrémité et la boîte de jonction du deuxième bord d'extrémité, les boîtes de jonction étant situées du même côté que le côté long, au moins une diode étant disposée dans la boîte de jonction au moins, et la diode étant inversement connectée en parallèle entre une électrode positive et une électrode négative de la chaîne de cellules photovoltaïques correspondant à la diode, et étant utilisée pour la protection contre le contournement.

4. Structure de réseau photovoltaïque à faible perte de ligne selon la revendication 3, dans laquelle l'espacement entre la première boîte de jonction d'extrémité et la deuxième boîte de jonction d'extrémité est compris entre 500 mm et 2000 mm.

5. Structure de réseau photovoltaïque à faible perte de ligne selon la revendication 1, 2, 3 ou 4, dans laquelle chaque module photovoltaïque comprend au moins deux chaînes de cellules photovoltaïques, chaque chaîne de cellules photovoltaïques comprenant au moins deux pièces de cellules (14a) connectées en série ou connectées en série de manière stratifiée, la pièce de cellule utilisant une pièce entière ou une tranche, et étant une plaquette de silicium cristallin, et la pièce de cellule entière ayant une longueur unilatérale comprise entre 100 mm et 260 mm.

6. Structure de réseau photovoltaïque à faible perte de ligne selon la revendication 5, dans laquelle une couche de conditionnement du module photovoltaïque comprend une couche de film composite flexible et/ou une couche de verre.

7. Structure de panneau photovoltaïque à faible perte de ligne selon la revendication 5, dans laquelle la diode est disposée dans chaque boîte de jonction, la pluralité de chaînes de cellules photovoltaïques réparties rangée par rangée ou colonne par colonne et connectées en série et/ou en parallèle sont réparties dans une direction du côté long, une seule diode est connectée inversement en parallèle entre l'électrode positive et l'électrode négative des au moins deux chaînes de cellules photovoltaïques réparties rangée par rangée ou colonne par colonne, et les diodes sont connectées en série et sont utilisées pour la protection par dérivation des chaînes de cellules photovoltaïques correspondant aux diodes.

8. Structure de réseau photovoltaïque à faible perte de ligne selon la revendication 7, dans laquelle 6n chaînes de cellules photovoltaïques réparties colonne par colonne et connectées en série et/ou en parallèle sont réparties sur le côté long, et une seule diode est connectée inversement en parallèle entre l'électrode positive et l'électrode négative de chaque 2n chaînes de cellules photovoltaïques réparties colonne par colonne, n étant un nombre entier positif égal ou supérieur à 1.

9. Structure de réseau photovoltaïque à faible perte de ligne selon la revendication 7, dans laquelle au moins deux chaînes de cellules photovoltaïques distribuées rangée par rangée, connectées en parallèle et comprenant 6n pièces de cellules sont distribuées sur le côté long, et une diode unique est connectée inversement en parallèle entre l'électrode positive et l'électrode négative de chaque 2n, 3n, ou 6n pièces de cellules dans chaque rangée, n étant un nombre entier positif égal ou supérieur à 1.

10. Structure de réseau photovoltaïque à faible perte de ligne selon la revendication 1, dans laquelle le module photovoltaïque utilise un assemblage intégré de tuiles d'acier de couleur photovoltaïque.

11. La structure de réseau photovoltaïque à faible perte de ligne selon la revendication 1, dans laquelle le module photovoltaïque utilise un module photovoltaïque au silicium cristallin léger et flexible laminé, comprenant une couche d'emballage avant, une chaîne de cellules photovoltaïques au silicium cristallin laminées et une couche d'emballage arrière qui sont laminées et emballées dans un ensemble, la couche d'emballage avant et la couche d'emballage arrière comprenant chacune une couche de film composite flexible, et la couche de film composite flexible ayant un poids ne dépassant pas 2 kg/cm²; le module photovoltaïque en silicium cristallin léger et flexible laminé comprend un côté long et un côté large, une première boîte de jonction de bord d'extrémité et une deuxième boîte de jonction de bord d'extrémité étant disposées sur des surfaces orientées vers la lumière ou des surfaces orientées à l'opposé de la lumière à deux extrémités le long d'une ligne centrale du côté long du module photovoltaïque respectivement, et étant situées sur le même côté du côté long du module photovoltaïque, les boîtes de jonction étant reliées électriquement au moyen de barres omnibus, et la première boîte de jonction de bord d'extrémité et/ou la deuxième boîte de jonction de bord d'extrémité étant reliées électriquement aux boîtes de jonction de bord d'extrémité du module photovoltaïque adjacentes à la première boîte de jonction de bord d'extrémité et/ou à la deuxième boîte de jonction de bord d'extrémité au moyen de connecteurs de câble, respectivement.

12. Structure de réseau photovoltaïque à faible perte de ligne selon la revendication 11, dans laquelle la couche de film composite flexible utilise un tissu de fibre composite d'un revêtement en poudre thermodurcissable.

13. Structure de réseau photovoltaïque à faible perte de ligne selon la revendication 12, dans laquelle le revêtement en poudre thermodurcissable utilise un revêtement en poudre thermodurcissable acrylique ou un revêtement en poudre thermodurcissable polyester.

14. Structure de réseau photovoltaïque à faible perte de ligne selon la revendication 11, dans laquelle une couche de film adhésif d'emballage est disposée entre la couche d'emballage avant et la chaîne de cellules photovoltaïques en silicium cristallin laminé.
